# EUROPÄISCHE PATENTSCHRIFT

(11) **EP 1 474 863 B1**
(45) Veröffentlichungstag und Bekanntmachung des Hinweises auf die Patenterteilung: **26.10.2005**
(21) Anmeldenummer: 03744327.2
(22) Anmeldetag: 23.01.2003
(51) Int. Cl.: H03F 1/30, H03F 3/21

(54) **Vorspannungsanordnung für parallelgeschaltete Transistoren.**
Biasing arrangement for paralleled transistors
Dispositif de polarisation pour transistors en parallèle

(30) Priorität: 19.03.2002 DE 10212165
(43) Veröffentlichungstag der Anmeldung: 10.11.2004
(73) Patentinhaber: Infineon Technologies AG, 81669 München (DE)
(72) Erfinder: FORSTNER, Johann-Peter, D-85643 Steinhöring (DE)
(74) Vertreter: Stöckeler, Ferdinand
(86) Internationale Anmeldenummer: PCT/EP2003/000670
(87) Internationale Veröffentlichungsnummer: WO 2003/079544

(56) Entgegenhaltungen:
- EP-A- 0 942 524
- WO-A-02/097969
- US-A- 3 967 207
- US-A- 6 046 642

## Beschreibung

Die vorliegende Erfindung bezieht sich auf eine Transistoranordnung und insbesondere eine solche Transistoranordnung, die eine Mehrzahl parallel geschalteter Transistoren, die gemeinsam einen Leistungsverstärker darstellen, aufweist.

Um den Kollektorstrom eines bipolaren Leistungstransistors zu messen, wird üblicherweise ein Widerstand in den Kollektor-Emitter-Pfad geschaltet. In analoger Weise wird bei Feldeffekttransistoren üblicherweise ein Widerstand in den Drain-Source-Pfad geschaltet, um den Drain-Strom zu messen.

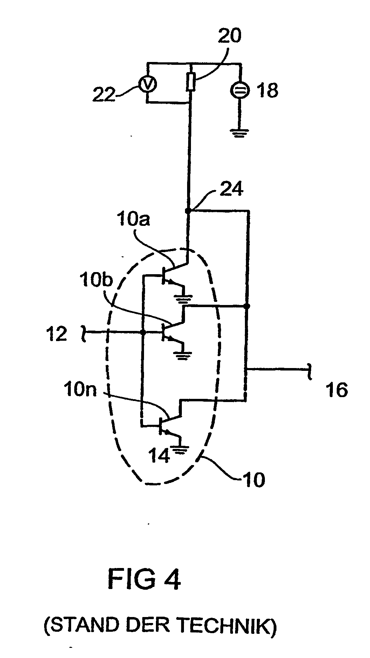

Die sich ergebende Schaltungsstruktur eines bipolaren Leistungstransistors 10 ist in Fig. 4 gezeigt. Der Leistungstransistor 10 besteht aus einer Mehrzahl von Einzeltransistoren, von denen drei Transistoren 10a, 10b und 10n in Fig. 4 gezeigt sind. Die Einzeltransistoren 10a, 10b und 10n sind dahin gehend parallel geschaltet, dass die Steueranschlüsse derselben mit einem HF-Eingang 12 der Transistoranordnung verbunden sind, die Kollektoranschlüsse derselben über einen Widerstand 20 mit einer Spannungsquelle 18 verbunden sind und ferner mit einem HF-Ausgang 16 der Transistoranordnung verbunden sind, und die Emitteranschlüsse derselben mit Masse verbunden sind. Die Spannungsquelle stellt eine Einrichtung zum Liefern des Arbeitsstroms des Leistungstransistors und damit der Einzeltransistoren 10a, 10b und 10n dar. Zwischen die Spannungsquelle 18 und einen Verzweigungspunkt 24, nach dem sich die Stromversorgungsleitung zu den einzelnen Transistoren 10a, 10b, ..., 10n verzweigt, ist ein Widerstand 20 geschaltet. Somit ist jeder der Einzeltransistoren 10a, 10b und 10n mit diesem Widerstand 20 beschaltet. Über den Spannungsabfall an diesem Widerstand 20 kann der Arbeitsstrom des Leistungstransistors, der durch die Summe der Kollektor-Emitter-Ströme der Einzeltransistoren gebildet ist, erfasst werden, wie in Fig. 4 schematisch durch einen Spannungsmesser 22 gezeigt ist.

Bei der in Fig. 4 gezeigten Schaltungsanordnung führt der Kollektorwiderstand 20 zu einer Reduktion der Kollektor-Emitter-Spannung von jedem der Einzeltransistoren und die Aussteuerbarkeit derselben wird beeinträchtigt. Ferner wird in dem Widerstand 20 Verlustleistung generiert. Insbesondere bei Anwendungen, die bei einer kleineren Versorgungsspannung arbeiten, beispielsweise im Mobilfunk oder bei Leistungsverstärkern, kann dies zu einer signifikanten Beeinträchtigung der Ausgangsleistung der Transistoranordnung und dem Wirkungsgrad derselben führen. Folglich wird die Sendezeit eines batteriebetriebenen Mobiltelefons reduziert.

Die Dokumente EP 942 524 und US 6 046 642 offenbaren weitere Vorspannungsschaltungen für HF-Verstärker.

Die Aufgabe der vorliegenden Erfindung besteht darin, eine Transistoranordnung zu schaffen, die eine verlustarme, einfache Möglichkeit bietet, ein Maß für den Arbeitsstrom eines oder mehrerer Transistoren der Transistoranordnung zu liefern.

Diese Aufgabe wird durch eine Transistoranordnung nach Anspruch 1 gelöst.

Die vorliegende Erfindung schafft eine Transistoranordnung mit folgenden Merkmalen:
einer Mehrzahl von parallel geschalteten Transistoren (32, 34, 36), deren Steueranschlüsse mit einem gemeinsamen HF-Eingang verbunden sind;
einem Stromweg (48) zum Zuführen eines Arbeitsstroms für die Transistoranordnung;
einer Mehrzahl von Unterstromwegen (50, 52, 54), die sich von dem Stromweg (48) verzweigen, zum Zuführen eines jeweiligen Arbeitsstroms zu jeweiligen ersten Anschlüssen der Mehrzahl von Transistoren;
einem in einen der Unterstromwege (50, 52, 54), der zu einem einzelnen der Mehrzahl von Transistoren führt, geschalteten Widerstand (60), wobei eine über den Widerstand (60) abfallende Spannung ein Maß für den Arbeitsstrom der Transistoranordnung ist, wobei zwischen dem ersten Anschluss des einzelnen der Mehrzahl von Transistoren und den ersten Anschlüssen der anderen der Mehrzahl von Transistoren eine Gleichsignalkopplung vorhanden ist; und
einer Einrichtung (70) zum Regeln des Arbeitsstroms der Transistoranordnung basierend auf der über dem Widerstand (60) abfallenden Spannung.

Die vorliegende Erfindung basiert auf der Erkenntnis, dass es möglich ist, zur Erfassung des Arbeitsstroms einer aus einer Mehrzahl von Transistoren gebildeten Transistoranordnung lediglich einen der Transistoren mit einem Widerstand zu beschalten und die über diesen Widerstand abfallende Spannung stellvertretend als Maß für den Arbeitsstrom der gesamten Transistoranordnung zu erfassen. Dies ist möglich, da der Arbeitsstrom durch den mit dem Widerstand beschalteten Transistor und die Arbeitsströme der anderen Transistoren eine determinierte Beziehung zueinander aufweisen.

Die über den Widerstand abfallende Spannung stellt ein Maß für den Arbeitsstrom der gesamten Transistoranordnung dar, und ferner ein Maß für die Arbeitsströme der einzelnen Transistoren, da der Arbeitsstrom der Transistoranordnung durch die Summe der Kollektor-Emitter-Ströme (Arbeitsströme) der Einzeltransistoren gebildet ist.

Somit wird erfindungsgemäß lediglich das Verhalten des einen Transistors, der mit dem Widerstand beschaltet ist und somit als Hilfstransistor betrachtet werden kann, durch die Beschaltung mit dem Widerstand beeinträchtigt. Ferner ist die in dem Widerstand umgesetzte Verlustleistung deutlich geringer als bei Beschaltung des gesamten Transistoranordnung mit dem Widerstand, d.h. bei Vorsehen des Widerstands in dem Stromweg, der den Arbeitsstrom der gesamten Transistoranordnung leitet.

Die vorliegende Erfindung ist insbesondere vorteilhaft anwendbar bei Leistungstransistoren, die grundsätzlich aus mehreren, teilweise bis zu mehreren hundert, parallel geschalteten Einzeltransistoren bestehen. Bei diesen Leistungstransistoren werden üblicherweise alle Transistoranschlüsse auf Busse zusammengeführt, wobei alle Einzeltransistoren, die auch als Transistorfinger bezeichnet werden, auf einem Halbleiterchip räumlich sehr eng aneinandergereiht sind und deshalb nahezu identische elektrische Eigenschaften aufweisen. Somit repräsentiert ein Einzeltransistor, d.h. Transistorfinger, die Eigenschaften des gesamten Leistungstransistors. Ermöglicht man somit die Erfassung eines Maßes für den Arbeitsstrom dieses Einzeltransistors, lässt dies einen Rückschluss auf den Arbeitsstrom der übrigen Transistoren des Leistungstransistor zu.

Bei einer solchen Anwendung der vorliegenden Erfindung auf einen Leistungstransistor, der aus vielen parallel geschalteten Einzeltransistoren besteht, geschieht die Strombestimmung somit quasi leistungslos. Da ferner lediglich die elektrischen Eigenschaften des beschalteten Einzeltransistors, nicht jedoch die elektrischen Eigenschaften aller anderen Transistoren des Leistungstransistors beeinflusst werden, werden die elektrischen Eigenschaften des gesamten Leistungstransistors kaum beeinflusst.

Vorzugsweise ist der mit dem Widerstand beschaltete Einzeltransistor zum Gesamttransistor voll HF-gekoppelt (hochfrequenzgekoppelt), d.h. Basis, Kollektor und Emitter führen nahezu exakt die gleichen HF-Signale wie entsprechende Transistoranschlüsse der nicht-beschalteten Transistoren, was bei der Parallelschaltung einer Mehrzahl von Transistoren in Leistungstransistoren der Fall ist. Bei einem solchen Aufbau werden auch Veränderungen im Umfeld des Gesamttransistors, beispielsweise Fehlanpassungen am HF-Ausgang, durch eine veränderte Stromaufnahme im mit dem Widerstand beschalteten Transistor widergespiegelt.

Bei bevorzugten Ausführungsbeispielen der vorliegenden Erfindung ist ferner eine Einrichtung vorgesehen, um basierend auf der über dem Widerstand abfallenden Spannung den Arbeitstrom des Leistungstransistors, und damit den jeweiligen Arbeitsstrom der einzelnen Transistoren derselben, einzustellen. Insbesondere kann der Arbeitsstrom des Gesamttransistors basierend auf der über dem Widerstand abfallenden Spannung auf einen konstanten Wert gesteuert werden.

Weiterbildungen der vorliegenden Erfindung sind in den abhängigen Ansprüchen dargelegt.

Bevorzugte Ausführungsbeispiele der vorliegenden Erfindung werden nachfolgend Bezug nehmend auf die beigefügten Zeichnungen näher erläutert. Es zeigen:
Fig. 1 ein Schaltungsdiagramm einer erfindungsgemäßen Transistoranordnung;
Fig. 2 eine Schaltungsdiagramm einer erfindungsgemäßen Transistoranordnung mit Arbeitsstromregelung;
Fig. 3 eine Schaltungsdiagramm einer alternativen erfindungsgemäßen Transistoranordnung mit Arbeitsstromregelung; und
Fig. 4 ein Schaltungsdiagramm einer herkömmlichen Transistoranordnung.

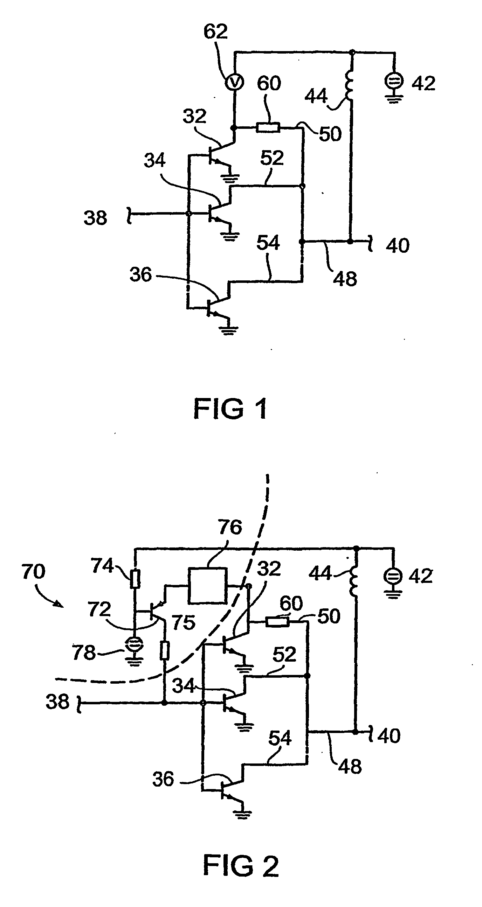

Bezug nehmend auf die Figuren 1 bis 3 werden nachfolgend bevorzugte Ausführungsbeispiele der vorliegenden Erfindung anhand bipolarer Leistungstransistoren näher erläutert. Es sei jedoch an dieser Stelle angemerkt, dass die vorliegende Erfindung in gleicher Weise auf dem Gebiet von Feldeffekttransistoren mit Gate, Drain und Source statt Basis, Kollektor und Emitter Anwendung finden kann.

Wie in Fig. 1 gezeigt ist, umfasst das dargestellte Ausführungsbeispiel der erfindungsgemäßen Transistoranordnung eine Mehrzahl von Bipolartransistoren 32, 34 und 36. Die Bipolartransistoren 32, 34 und 36 sind parallel geschaltet und bilden gemeinsam einen Leistungstransistor, der, wie durch die aufgebrochenen Linien in Fig. 1 angezeigt ist, in der Regel durch eine weit größere Anzahl, beispielsweise mehrere Hundert, von Einzeltransistoren gebildet ist.

Die Bipolartransistoren 32, 34 und 36 sind parallel geschaltet dahingehend, dass die Basisanschlüsse, d.h. die Steueranschlüsse, derselben mit einem HF-Eingang 38 verbunden sind, die Emitteranschlüsse derselben mit Masse verbunden sind und die Kollektoranschlüsse derselben mit einem HF-Ausgang 40 gekoppelt sind. Ein Arbeitsstrom der Transistoranordnung wird durch eine Spannungsquelle 42 geliefert, die über eine Spule 44, die zur HF-Entkopplung dient, mit einem Stromweg 48, der den gesamten Arbeitsstrom für die Transistoranordnung führt, verbunden ist. Der Stromweg 48 verzweigt sich in einzelne Teilleitungen 50, 52 und 54 bzw. Unterstromwege, die jeweils mit den Kollektoranschlüssen der Transistoren 32, 34 und 36 verbunden sind.

Wie in Fig. 1 zu sehen ist, sind die Kollektoranschlüsse der Transistoren 34 und 36 über die Teilleitungen 52 und 54 direkt mit dem Stromweg 48 verbunden, während ein Widerstand 60 in die Teilleitung 50 geschaltet ist. Ferner ist in Fig. 1 zu veranschaulichenden Zwecken ein Spannungsmesser 62 dargestellt, der das Erfassen der über den Widerstand 60 abfallenden Spannung ermöglicht, da die Spule 44 für den betrachteten Gleichstrom einen Kurzschluss darstellt. Alternativ zu der dargestellten Verschaltung könnte der Spannungsmesser 62 direkt parallel zu dem Widerstand 60 geschaltet sein.

Bei der in Fig. 1 gezeigten Transistoranordnung liefert die Spannungsquelle 42 einen Arbeitsstrom für die gesamte Transistoranordnung über die Spule 44 auf dem Stromweg 48. An der Verzweigung des Stromwegs 48 teilt sich dieser Gesamtstrom in einzelne, den Einzeltransistoren auf den Teilleitungen 50, 52 und 54 zugeführte Teilströme auf. Der dem Transistor 32 zugeführte Teilstrom ist durch den in die Teilleitung 50 geschalteten Widerstand 60 erfassbar, indem eine über denselben abfallende Spannung erfasst wird. Erfindungsgemäß ist somit der Widerstand 60 nicht in den den Gesamtarbeitsstrom der Transistoranordnung führenden Stromweg geschaltet, sondern in den den Arbeitsstrom von nur einem Einzeltransistor führenden Stromweg.

Die Ströme durch die Leitungen 50, 52 und 54 stehen aufgrund des Stromteilers, der sich durch die Verzweigung des Stromwegs 48 in die Unterstromwege 50, 52 und 54 ergibt, sowie der Beschaltung der jeweiligen Teilleitungen in einem determinierten Verhältnis zueinander. Somit kann durch die an dem Widerstand 60 abfallende Spannung auf die Ströme durch die Leiter 52 und 54 rückgeschlossen werden. Darüber hinaus können durch ein Steuern der an dem Widerstand 60 abfallenden Spannung der gesamte Arbeitsstrom bzw. die Arbeitsströme der Einzeltransistoren gesteuert werden.

Bei der in Fig. 1 gezeigten Schaltungsanordnung ist der Hilfstransistorfinger, d.h. der Transistor 32 mit dem Widerstand 60, zum Gesamttransistor voll HF-gekoppelt, d.h. Basis, Kollektor und Emitter führen nahezu exakt die gleichen Hochfrequenzsignale wie die entsprechenden Transistoranschlüsse der restlichen Transistoren. Der einzige Unterschied hierbei besteht in einer geringeren durch den Hilfstransistor 32 gelieferten Verstärkung aufgrund der Verstellung des Arbeitspunktes desselben durch die Beschaltung mit dem Widerstand 60. Dieser Effekt ist jedoch vernachlässigbar, wobei dennoch Veränderungen im Umfeld des Gesamttransistors, z.B. eine Fehlanpassung am Ausgang 40 desselben, durch eine veränderte Stromaufnahme im Hilfstransistor widergespiegelt werden.

Fig. 2 zeigt ein Ausführungsbeispiel der vorliegenden Erfindung, das eine Einrichtung zum Regeln des Arbeitsstroms des Leistungstransistors basierend auf der über dem Widerstand 60 abfallenden Spannung aufweist. Dabei sind in Fig. 2 Elemente, die denen in Fig. 1 entsprechen, mit dem gleichen Bezugszeichen bezeichnet.

Gemäß Fig. 2 ist der in Fig. 1 schematisch dargestellte Spannungsmesser 62 durch ein Regelglied 70 ersetzt, durch das der Spannungsabfall an dem Widerstand 60 konstant gehalten werden kann, so dass auch der Arbeitsstrom des Gesamttransistors konstant gehalten wird.

Das Regelglied 70 umfasst einen Transistor 72, Widerstände 74 und 75, ein Schleifentiefpassfilter 76 und eine Konstantstromquelle 78. Bei dem dargestellten Ausführungsbeispiel ist der Transistor 72 ein pnp-Transistor, während die Transistoren 32, 34 und 36 npn-Transistoren sind.

Der Emitteranschluss des Transistors 72 ist über das Schleifentiefpassfilter 76 mit dem Kollektoranschluss des Transistors 32 verbunden. Der Kollektoranschluss des Transistors 72 ist über den Widerstand 75 mit dem Basisanschluss der Transistoren 32, 34 und 36 verbunden. Der Basisanschluss des Transistors ist über die Konstantstromquelle 78 mit Masse und über den Wiederstand 74 mit der Spannungsquelle 42 verbunden. Die Konstantstromquelle 78 liefert einen definierten Spannungsabfall über den Widerstand 74 mit einem Offset durch die Spannungsquelle 42.

Zur Erläuterung der Funktionsweise des Regelglieds 70 sei zunächst davon ausgegangen, dass der Arbeitsstrom einen vorbestimmten Wert aufweist, der einen bestimmten Spannungsabfall über dem Widerstand 60 zur Folge hat. Ändert sich der Arbeitsstrom, so ändert sich die über dem Widerstand 60 anliegende Spannung und somit das am Emitteranschluss des Transistors 72 anliegende Potential, wobei durch das Schleifentiefpassfilter 76 hochfrequente Änderungen gesperrt werden.

Genauer gesagt nimmt das Potential am Emitteranschluss des Transistors 72 ab, wenn der Spannungsabfall über den Widerstand 60 zunimmt, während das Potential am Emitteranschluss des Transistors 72 zunimmt, wenn der Spannungsabfall über den Widerstand 60 abnimmt.

Durch ein reduziertes Potential am Emitteranschluss des Transistors 72 nimmt die Basis-Emitter-Spannung und somit der Kollektor-Emitter-Strom des Transistors 72 ab. Damit reduziert sich der den Transistoren 32, 34 und 36 zur Verfügung stehende Basisstrom, so dass der Arbeitsstrom derselben, d.h. der Kollektor-Emitter-Strom derselben, abnimmt. Dadurch reduziert sich der Strom durch den Widerstand 60 und somit der Spannungsabfall über denselben.

Dagegen erhöht sich durch ein erhöhtes Potential am Emitteranschluss des Transistors 72, wie es durch einen reduzierten Spannungsabfall am Widerstand 60 bewirkt wird, die Basis-Emitter-Spannung und somit der Kollektor-Emitter-Strom desselben. Dadurch erhöht sich der den Transistoren 32, 34 und 36 zur Verfügung stehende Basisstrom, so dass der Arbeitsstrom derselben, d.h. der Kollektor-Emitter-Strom derselben, zunimmt. Dadurch erhöht sich der Strom durch den Widerstand 60 und somit der Spannungsabfall über denselben.

Somit wird entsprechend der obigen Ausführungen der Arbeitsstrom durch den Gesamttransistor durch das in Fig. 2 gezeigte Regelglied 70 auf einen konstanten Wert geregelt.

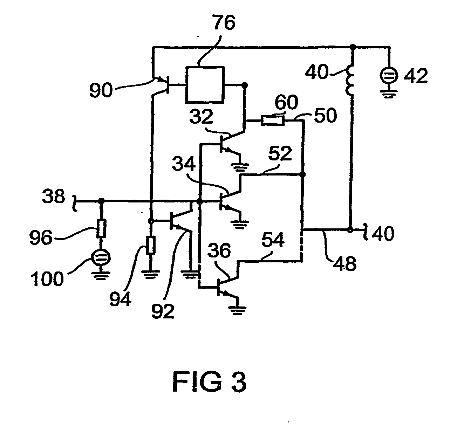

Ein weiteres Ausführungsbeispiel zum Regeln des Arbeitsstroms der Transistoranordnung ist in Fig. 3 gezeigt, die wiederum ein Regelglied darstellt, durch das der Spannungsabfall an dem Widerstand 60 konstant gehalten werden kann, so dass auch der Arbeitsstrom des Gesamttransistors konstant gehalten wird.

Das in Fig. 3 gezeigte Regelglied umfasst ein Schleifentiefpassfilter 76, einen pnp-Transistor 90, einen npn-Transistor 92, Widerstände 94 und 96 und eine Spannungsquelle 100. Das Schleifenfilter 76 ist zwischen den Kollektoranschluss des Transistors 32 und den Basisanschluss des pnp-Transistors 90 geschaltet. Der Emitteranschluss des pnp-Transistors 90 ist mit der Spannungsquelle 42 verbunden. Der Kollektoranschluss des pnp-Transistors 90 ist über den Widerstand 94 mit Masse verbunden. Ferner ist der Kollektoranschluss des pnp-Transistors 90 mit dem Basisanschluss des npn-Transistors 92 verbunden. Der Emitteranschluss des Transistors 92 ist mit Masse verbunden und der Kollektoranschluss desselben ist mit dem Basisanschluss der Transistoren 32, 34 und 36 verbunden. Schließlich ist eine Serienschaltung aus dem Widerstand 96 und der Spannungsquelle 100 zwischen den Basisanschluss der Transistoren 32, 34 und 36 und Masse geschaltet.

Die Regelung des Arbeitsstroms durch den obigen Aufbau wird im folgenden erläutert. Ändert sich der Arbeitsstrom der Transistoranordnung ausgehend von einem gewünschten Arbeitsstrom, so ändert sich die über den Widerstand 60 abfallende Spannung. Bedingt dadurch ändert sich das an dem Basisanschluss des pnp-Transistors 90 anliegende Potential, wobei durch das Schleifentiefpassfilter 76 hochfrequente Änderungen gesperrt werden. Genauer gesagt nimmt das Potential am Basisanschluss des Transistors 90 ab, wenn der Spannungsabfall über den Widerstand 60 zunimmt, und umgekehrt. Durch das geänderte Potential am Basisanschluss des Transistors 90 ändert sich der Kollektor-Emitter-Strom desselben. Genauer gesagt nimmt der Kollektor-Emitter-Strom durch den Transistor 90 zu, wenn des Potential am Basisanschluss desselben abnimmt, und umgekehrt.

Die Änderung des Kollektor-Emitterstroms des Transistors ändert sich der Spannungsabfall über den Widerstand 94 und damit das an der Basis des Widerstands 92 anliegende Potential. Damit ändert sich der Kollektor-Emitterstrom des Transistors 92 und somit der Strom, der durch diesen Transistor vom Basisstrom der Transistoren 32, 34 und 36 abgezogen wird. Damit reduziert sich der Basisstrom der Transistoren 32, 34 und 36, wenn der Spannungsabfall über den Widerstand 60 und damit der Spannungsabfall über den Widerstand 94 zunimmt, während der Basisstrom in die Transistoren 32, 34 und 36 zunimmt, wenn der Spannungsabfall über den Widerstand 60 und damit der Spannungsabfall über den Widerstand 94 abnimmt.

Entsprechend der Änderung des Basisstroms der Transistoren 32, 34 und 36 ändert sich der durch dieselben gezogene Emitter-Kollektor-Strom derselben und damit der Arbeitsstrom der Transistoranordnung. Somit wird auch gemäß dem in Fig. 3 gezeigten Beispiel der Arbeitsstrom auf einen konstanten Wert geregelt.

Es sei an dieser Stelle angemerkt, dass die bezugnehmend auf die Fig. 2 und 3 beschriebenen Regelglieder lediglich Beispiele darstellen und dass für Fachleute eine Vielzahl modifizierter Regelglieder ersichtlich ist. Der Eingriff der Regelung kann dabei sowohl in den Bias des Leistungstransistors, d.h. der einzelnen Transistoren derselben, oder auch in einen dem als Endstufentransistor wirkenden Leistungstransistor vorgeschalteten Verstärker erfolgen. Hierbei kann auch die Eingangsleistung des Endstufentransistors reduziert werden, so dass dessen Stromaufnahme sinkt.

Neben einer Konstantstromregelung, wie sie oben Bezug nehmend auf die Fig. 2 erläutert wurde, können andere Stromregelungen, die auf der Grundlage der über dem Widerstand 60 abfallenden Spannung arbeiten, realisiert werden. Insbesondere ist es möglich, eine Regelung vorzusehen, die eine Strombegrenzung und somit einen Überlastschutz bietet. Dies kann bei Leistungstransistoren, insbesondere im Mobilfunk, bei denen sehr häufig hohe Kollektorströme auftreten, vorteilhaft sein. Solche hohen Kollektorströme können beispielsweise durch Fehlanpassungen am Ausgang hervorgerufen werden, wobei der Transistor durch diese hohen Kollektorströme Schaden nehmen kann. Unter Verwendung eines geeigneten Regelgliedes kann der Kollektorstrom aller Transistoren eines Leistungstransistors basierend auf der über dem Widerstand, mit dem lediglich der Hilfstransistorfinger beschaltet ist, abfallenden Spannung auf einen definierten Maximalwert begrenzt werden. Dadurch kann einer dauerhaften Schädigung des Leistungstransistors vorgebeugt werden.

Darüber hinaus kann die vorliegende Erfindung verwendet werden, um eine Hochfrequenz-Ausgangsleistungsbegrenzung und eine Hochfrequenz-Ausgangsleistungsstellung durchzuführen. Um den Wirkungsgrad zu optimieren, werden Hochfrequenzleistungsendstufen häufig im AB-, B- und C-Betrieb abhängig von der Arbeitspunkteinstellung betrieben. In diesen Betriebsmodi besteht ein sehr genauer Zusammenhang zwischen Endstufenstrom, d.h. Arbeitsstrom der Hochfrequenzleistungsendstufe, und Hochfrequenzausgangsleistung. Sind die Transistoren einer solchen Leistungsendstufe in Folge hoher Eingangsleistung in Kompression, kann durch eine Kollektorstrombegrenzung, die wiederum auf der Grundlage der über den erfindungsgemäß verschalteten Widerstand abfallenden Spannung erfolgt, die Hochfrequenzausgangsleistung gestellt werden.

Neben den oben angesprochenen Ausführungsbeispielen kann auf der Grundlage der Erfassung des Stroms durch einen Hilfstransistorfinger, wie sie erfindungsgemäß durchgeführt wird, jegliche Stromregelung durch die übrigen Transistorfinger durchgeführt werden, da die Ströme durch die verschiedenen Finger ein reproduzierbares Verhältnis zueinander aufweisen. Die vorliegende Erfindung schafft somit die Möglichkeit, eine Arbeitsstromregelung für Transistoranordnungen mit einer Mehrzahl von Transistoren zu schaffen, die zum einen die Kollektor-Emitter-Spannungen der Einzeltransistoren, mit Ausnahme des mit dem Widerstand beschalteten Transistors, nicht signifikant reduziert und zum anderen wenig Verlustleistung generiert. Erfindungsgemäß wird dies ermöglicht, indem nicht der gesamte Leistungstransistor mit dem Widerstand beschaltet wird, sondern lediglich ein Einzeltransistor, d.h. Einzeltransistorfinger, der Mehrzahl von Transistoren.

### Bezugszeichenliste

- 10: Leistungstransistor
- 10a, 10b, 10n: Einzeltransistoren
- 12: HF-Eingang
- 14: Masse
- 16: HF-Ausgang
- 18: Spannungsquelle
- 20: Widerstand
- 22: Spannungsmesser
- 24: Verzweigungspunkt
- 32, 34, 36: Einzeltransistoren
- 38: HF-Eingang
- 40: HF-Ausgang
- 42: Spannungsquelle
- 44: Spule
- 48: Gesamtleitung
- 50, 52, 54: Teilleitungen
- 60: Widerstand
- 62: Spannungsmesser
- 70: Regelglied
- 72: Transistor
- 74, 75: Widerstände
- 76: Schleifentiefpaßfilter
- 78: Konstantstromquelle
- 90: pnp-Transistor
- 92: npn-Transistor
- 94, 96: Widerstände
- 100: Spannungsquelle

## Patentansprüche

1. Transistoranordnung mit folgenden Merkmalen:
einer Mehrzahl von parallel geschalteten Transistoren (32, 34, 36), deren Steueranschlüsse mit einem gemeinsamen HF-Eingang verbunden sind;
einem Stromweg (48) zum Zuführen eines Arbeitsstroms für die Transistoranordnung;
einer Mehrzahl von Unterstromwegen (50, 52, 54), die sich von dem Stromweg (48) verzweigen, zum Zuführen eines jeweiligen Arbeitsstroms zu jeweiligen ersten Anschlüssen der Mehrzahl von Transistoren;
einem in einen der Unterstromwege (50, 52, 54), der zu einem einzelnen der Mehrzahl von Transistoren führt, geschalteten Widerstand (60), wobei eine über den Widerstand (60) abfallende Spannung ein Maß für den Arbeitsstrom der Transistoranordnung ist, wobei zwischen dem ersten Anschluss des einzelnen der Mehrzahl von Transistoren und den ersten Anschlüssen der anderen der Mehrzahl von Transistoren eine Gleichsignalkopplung vorhanden ist; und
einer Einrichtung (70) zum Regeln des Arbeitsstroms der Transistoranordnung basierend auf der über dem Widerstand (60) abfallenden Spannung.

2. Transistoranordnung nach Anspruch 1, bei der die Einrichtung (70) zum Regeln des Arbeitsstroms eine Einrichtung zum Einstellen der Verstärkung der Transistoren (32, 34, 36) basierend auf der über dem Widerstand (60) abfallenden Spannung aufweist.

3. Transistoranordnung nach Anspruch 2, bei der die Einrichtung zum Einstellen der Verstärkung der Transistoren die Verstärkung derselben derart einstellt, dass der Arbeitsstrom der Transistoranordnung auf einen konstanten Wert geregelt wird.

4. Transistoranordnung nach Anspruch 3, bei der die Einrichtung zum Einstellen der Verstärkung einen Transistor (72) aufweist, an dessen Steuereingang ein von der über den Widerstand (60) abfallenden Spannung abhängiges Potential anliegt.

5. Transistoranordnung nach Anspruch 4, bei der die Einrichtung zum Einstellen der Verstärkung der Transistoren die Verstärkung derselben derart einstellt, dass der Arbeitsstrom der Transistoranordnung einen maximalen Wert nicht übersteigt.

## Claims

1. A transistor assembly comprising:
a plurality of transistors (32, 34, 36) connected in parallel, the control terminals of which are connected to a common HF input;
a current path (48) for feeding an operating current for the transistor assembly;
a plurality of sub-current paths (50, 52, 54) branching off from the current path (48) for feeding a respective operating current to respective first terminals of the plurality of transistors;
a resistor (60) connected into one of the sub-current paths (50, 52, 54) leading to an individual one of the plurality of transistors, wherein a voltage across the resistor (60) is a measure of the operating current of the transistor assembly, direct signal coupling occurring between the first terminal of the individual one of the plurality of transistors and the first terminals of the other ones of the plurality of transistors; and
means (70) for regulating the operating current of the transistor assembly based on the voltage across the resistor (60).

2. The transistor assembly according to claim 1, wherein the means (70) for regulating the operating current comprises means for adjusting the amplification of the transistors (32, 34, 36) based on the voltage across the resistor (60).

3. The transistor assembly according to claim 2, wherein the means for adjusting the amplification of the transistors adjusts the amplification thereof such that the operating current of the transistor assembly is regulated to a constant value.

4. The transistor assembly according to claim 3, wherein the means for adjusting the amplification comprises a transistor (72) at the control input of which there is a potential depending on the voltage across the resistor (60).

5. The transistor assembly according to claim 4, wherein the means for adjusting the amplification of the transistors adjusts the amplification thereof such that the operating current of the transistor assembly does not exceed a maximum value.

## Revendications

1. Dispositif à transistors ayant les caractéristiques suivantes :
une multiplicité de transistors (32, 34, 36) montés en parallèle, dont les bornes de commande sont reliées à une entrée HF commune ;
une voie (48) de courant pour envoyer un courant de travail pour le dispositif à transistors ;
une multiplicité de sous-voies (50, 52, 54) de courant, qui bifurquent de la voie (48) de courant pour envoyer un courant de travail respectif à des premières bornes respectives de la multiplicité de transistors ;
une résistance (60) montée dans l'une des sous-voies (50, 52, 54) de courant, qui mène à l'un de la multiplicité des transistors, une tension chutant aux bornes de la résistance (60) étant une mesure du courant de travail du dispositif à transistors, un couplage en signal continu étant présent entre la première borne de l'un de la multiplicité de transistors et les premières bornes de l'autre de la multiplicité de transistors ; et
un dispositif (70) de régulation du courant de travail du dispositif à transistors basé sur la tension chutant aux bornes de la résistance (60).

2. Dispositif à transistor suivant la revendication 1, dans lequel le dispositif (70) de régulation du courant de travail comporte un dispositif de régulation de l'amplification des transistors (32, 34, 36) reposant sur la tension chutant aux bornes de la résistance (60).

3. Dispositif à transistor suivant la revendication 2, dans lequel le dispositif de régulation de l'amplification des transistors en règle l'amplification de manière à ce que le courant de travail du dispositif à transistors soit régulé à une valeur constante.

4. Dispositif à transistor suivant la revendication 3, dans lequel le dispositif de réglage de l'amplification comporte un transistor (72) à l'entrée de commande duquel s'applique un potentiel qui dépend de la tension chutant aux bornes de la résistance (60).

5. Dispositif à transistor suivant la revendication 4, dans lequel le dispositif de réglage de l'amplification des transistors en règle l'amplification de façon à ce que le courant de travail du dispositif à transistors ne dépasse pas une valeur maximum.
